(19) Europäisches Patentamt

European Patent Office

Office européen des brevets

(11) Veröffentlichungsnummer: **0 005 513**
**B1**

(12) **EUROPÄISCHE PATENTSCHRIFT**

(45) Veröffentlichungstag der Patentschrift:
20.01.82

(21) Anmeldenummer: **79101433.5**

(22) Anmeldetag: **10.05.79**

(51) Int. Cl.³: **B 65 G  1/12,** H 05 K  13/00

(54) Montageeinrichtung zur Bestückung von Trägerplatten mit Bauelementen.

(30) Priorität: **19.05.78 DE 2821926**

(43) Veröffentlichungstag der Anmeldung:
**28.11.79 Patentblatt 79/24**

(45) Bekanntmachung des Hinweises auf die Patenterteilung:
**20.01.82 Patentblatt 82/3**

(84) Benannte Vertragsstaaten:
**AT BE CH FR GB IT NL SE**

(56) Entgegenhaltungen:
**DE-A-2 204 347**
**FR-A-1 427 294**
**Prospekt «Rogonie» der Royonie Vertriebs GmbH,**
**München**

(73) Patentinhaber: **Spörer, Bernhard, Münchener**
**Strasse 12a, D-8011 Faistenhaar (DE)**

(72) Erfinder: **Spörer, Bernhard, Münchener Strasse 12a,**
**D-8011 Faistenhaar (DE)**

(74) Vertreter: **Weickmann, Heinrich, Dipl.-Ing. et al,**
**Postfach 860 820 Möhlstrasse 22,**
**D-8000 München 86 (DE)**

## Montageeinrichtung zur Bestückung von Trägerplatten mit Bauelementen

Die Erfindung betrifft eine Montageeinrichtung zur Bestückung von Trägerplatten mit Bauelementen, insbesondere zur Bestückung von Schaltungsträgerplatinen mit elektrischen Bauelementen mit einer Arbeitsfläche, mit einer Halterung für die Trägerplatte an der Oberseite der Arbeitsfläche und mit unterhalb der Arbeitsfläche längs einer Führungsbahnschleife geführten Aufnahmen für die Bauelemente, von denen jeweils mindestens eine Aufnahme durch eine Entnahme-Öffnung in der Arbeitsfläche zugänglich ist, wobei die Achse der Führungsbahnschleife horizontal liegt und die Aufnahmen in Richtung der Schleifenachse länglich ausgebildet sind.

Eine Montageeinrichtung dieser Art ist bekannt (Prospekt «Royonic» der Royonic Vertriebs GmbH, Limburgstrasse 12, D-8000 München 90). Auf Grund der länglichen Ausbildung der Aufnahmen ergibt sich zwar eine hohe Aufnahmekapazität für Bauelemente; die an der Montageeinrichtung arbeitende Bedienungsperson muss jedoch bei der Entnahme von Bauelementen unterschiedliche Zugriffwege zwischen der gerade zugänglichen Aufnahme und der Halterung für die Trägerplatte mit der Hand zurücklegen, je nachdem an welcher Stelle der länglichen Aufnahme sich das gerade gewünschte Bauteil befindet.

Demgegenüber ist es Aufgabe der Erfindung, eine Montageeinrichtung der eingangs genannten Art mit verbesserter Zugriffmöglichkeit bereitzustellen.

Diese Aufgabe wird dadurch gelöst, dass die Gesamtheit der Aufnahmen in Richtung der Schleifenachse verschiebbar ist. Die gerade zugängliche Aufnahme kann daher derart verschoben werden, dass das jeweils gewünschte Bauteil immer an der gleichen Stelle entnommen werden kann, beispielsweise in unmittelbarer Nähe der Halterung für die Trägerplatte. Hierdurch wird die Montage wesentlich erleichtert, da die Zugriffshand stets den gleichen Weg zurückzulegen hat. Ein weiterer Vorteil ergibt sich daraus, dass die maximale Länge der Aufnahmen nicht mehr durch die Reichweite der Hand der Bedienungsperson begrenzt ist. Es können daher zur Vergrösserung der Aufnahmekapazität der Montageeinrichtung auch längere Aufnahmen eingesetzt werden.

Eine Montageeinrichtung mit horizontaler Achse der Führungsbahnschleife ist auch aus der DE-OS 2 431 398 bekannt. Die längliche Führungsbahnschleife verläuft hier im wesentlichen vertikal hinter der von der Bedienungsperson abgelegenen Kante der Arbeitsfläche. Oberhalb der Arbeitsfläche ist die Führungsbahnschleife zur Bedienungsperson hin vorgewölbt, um die Aufnahmen in eine der Bedienungsperson nähergelegene Entnahmeposition zu bringen. Diese Position ist ergonomisch sehr ungünstig, da die Bedienungsperson zur Entnahme entsprechend hoch greifen muss, während bei der erfindungsgemässen Montageeinrichtung die Aufnahmen durch die Öffnung in der Arbeitsfläche zugänglich sind. In letzterem Falle kann die Bedienungsperson die Bauelemente in einer entspannten Haltung mit aufgelegten Unterarmen der Aufnahmen entnehmen. Länger andauernde Bestückungsarbeiten werden hierdurch wesentlich erleichtert.

In einer vorteilhaften Ausgestaltung der Erfindung sind die Aufnahmen zwischen zwei in Längsrichtung der Schleifenachse beabstandeten, flexiblen, endlosen Zugmitteln, z.B. Ketten, an diesen beidendig befestigt angeordnet, wobei die Zugmittel auf einem Schlitten angeordnet sind, welche in Richtung der Schleifenachse in einer Schlittenführung verschiebbar ist. Diese Anordnung ist mechanisch robust und arbeitet daher zuverlässig.

Dadurch, dass die Zugmittel im Bereich der der Bedienungsperson zugewandten Kante der Arbeitsfläche über je eine Einzelumlenkrolle geführt sind, derart, dass die Aufnahmen zwischen den Einzelumlenkrollen in deren Achsbereich eindringen können, lassen sich Einzelumlenkrollen mit entsprechend kleinem Durchmesser einsetzen, da die Aufnahmen nicht um die Achsen der Einzelumlenkrollen herumgeführt werden müssen. Der Raumbedarf für die Einzelumlenkrollen sowie die zu den Einzelumlenkrollen hin und von diesen weggeführten Aufnahmen in vertikaler Richtung ist entsprechend gering, so dass die an der Arbeitsfläche sitzende Bedienungsperson mit den Knien bequem unterhalb den Einzelumlenkrollen und den Aufnahmen Platz findet. Im Bereich der der Bedienungsperson abgewandten Kante der Arbeitsfläche werden die Zugmittel vorteilhafterweise über Synchronisierumlenkrollen mit sie verbindender Synchronisierwelle geführt, wobei der Durchmesser der Synchronisierumlenkrollen derart bemessen ist, dass die Aufnahmen um die Synchronisierwelle herumlaufen. Auf diese Weise wird mit einfachen Mitteln erreicht, dass die beiden Zugmittel streng synchron laufen.

Der Raum unterhalb der Arbeitsfläche der erfindungsgemässen Montageeinrichtung kann dadurch weitgehend genutzt werden, dass die Länge der Aufnahmen in Richtung der Schleifenachse mindestens ca. 30%, vorzugsweise ca. 50% der Ausdehnung der Arbeitsfläche in dieser Richtung beträgt.

Für einfache Bestückungsarbeitung, wie die Bestückung von Schaltungsträgerplatinen, ist es ergonomisch günstig, die Entnahme-Öffnung in dem der Bedienungsperson zugekehrten Randbereich der Arbeitsfläche anzuordnen, also zwischen der Bedienungsperson und der Trägerplatte auf der Arbeitsfläche.

Sind an der Trägerplatte jedoch komplizierte Handgriffe, wie Einschrauben von Bauteilen, vorzunehmen, ist es günstiger, die Entnahme-Öffnung in dem der Bedienungsperson abgewandten Randbereich der Arbeitsfläche vorzusehen, d.h. mit der Trägerplatte zwischen Bedienungsperson und Entnahme-Öffnung. Die Schraubarbeiten lassen sich besser an der direkt vor der Arbeitsperson befindlichen Trägerplatte durchführen.

Insbesondere bei langen Aufnahmen ist es zweckmässig, die Schleifenachse parallel zu der der Bedienungsperson zugekehrten Kante der Arbeitsfläche anzuordnen, da dann die Aufnahmen mit ihrer gesamten Länge unter die in einem der angesprochenen Randbereiche liegende Entnahme-Öffnung gebracht werden können.

Weitere Merkmale der Erfindung ergeben sich aus den Unteransprüchen, soweit diese nicht schon im Vorstehenden diskutiert worden sind.

Die beiliegenden Figuren erläutern die Erfindung. Es zeigt:

Fig. 1 eine perspektivische Ansicht einer Montageeinrichtung mit aufgestapelten Gefässen,

Fig. 2 eine Draufsicht auf eine erfindungsgemässe Montageeinrichtung mit teilweise abgebrochenem Abdeckblech,

Fig. 3 eine Seitenansicht der Montageeinrichtung nach Fig. 2 im Schnitt entlang der Linie V–V,

Fig. 4 eine geschnittene Detailansicht der Montageeinrichtung nach den Fig. 2 und 3 in Richtung des Pfeils VI in Fig. 2.

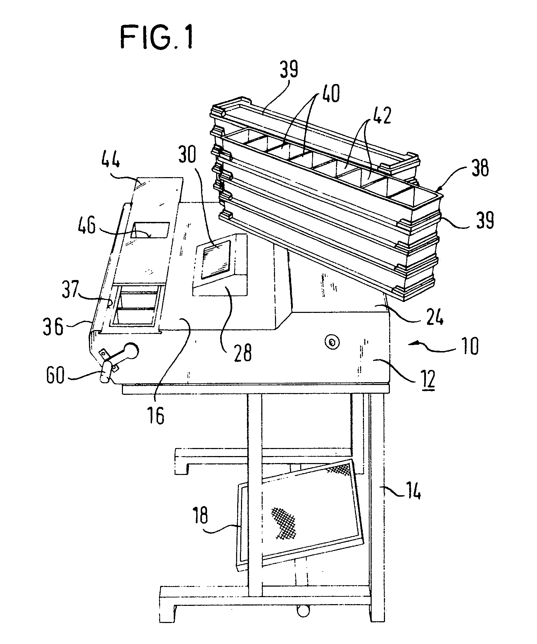

Die in Fig. 1 gezeigte Montageeinrichtung, für die als solche kein Schutz beansprucht wird, ist allgemein mit 10 bezeichnet. Sie besteht aus einem Bauteilezuführaufsatz 12, der von einem Untergestell 14 getragen wird. Die grosse obere Fläche, die Arbeitsfläche 16, des Bauteilezuführaufsatzes 12 befindet sich in der üblichen Arbeitshöhe für eine an der Montageeinrichtung 10 sitzende Bedienungsperson.

Am Untergestell 14 ist eine Fussstütze 18 angebracht. Aufgrund der geringen Bauhöhe des Bauteilezuführaufsatzes 12 im Bereich der Arbeitsfläche 16 von weniger als 20 cm kann man auch auf ein eigenes Untergestell 14 verzichten und den Bauteilezuführaufsatz 12 auf einen vorhandenen Arbeitstisch auflegen.

Der Bauteilezuführaufsatz 12 besteht aus einem Gehäuse 20 aus Metallblech mit einem das Gehäuse 20 nach oben abdeckenden Abdeckblech 22. Das Abdeckblech 22 besitzt einen gegenüber der Arbeitsfläche 16 erhöhten Bereich 24, um Synchronisierumlenkrollen innerhalb des Gehäuses 20 Raum zu schaffen.

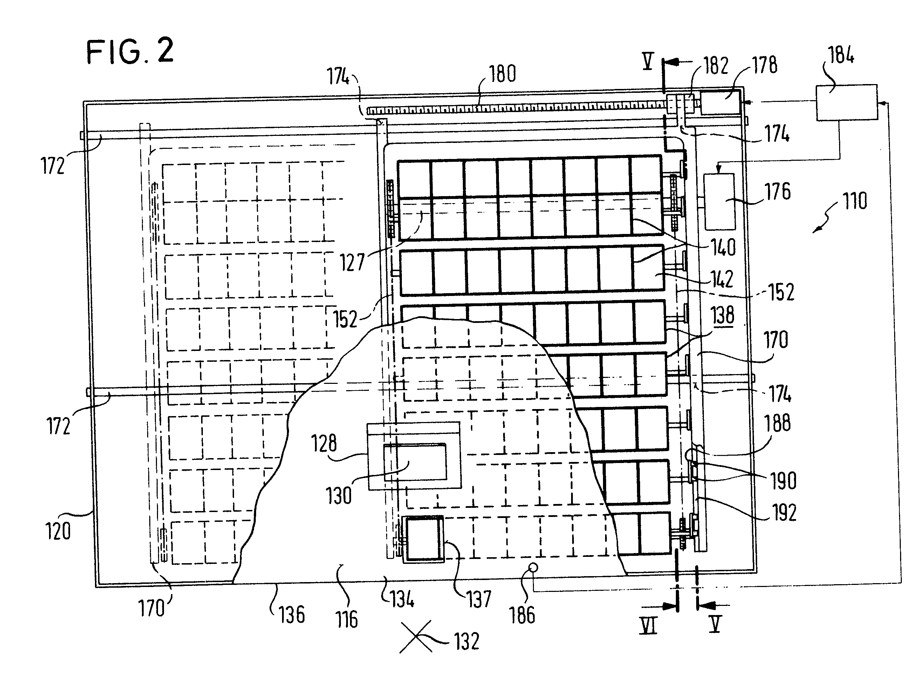

Auf der Arbeitsfläche 16 ist eine Halterung 28 für eine zu bestückende Trägerplatte 30 angebracht. Die Trägerplatte 30 selbst ist an der Halterung mit nichtdargestellten Mitteln befestigt. Der Sitzplatz 32 der Bedienungsperson ist in Fig. 2 durch ein Kreuz symbolisiert. Der der Bedienungsperson zugekehrte Randbereich 34 der Arbeitsfläche 16 ist mit einer Entnahme-Öffnung 37 versehen, die sich längs der Kante 36 der Arbeitsfläche 16 erstreckt.

Unterhalb der Öffnung 37 befindet sich eines von acht Gefässen 38, die mittels eines Kettenantriebes der Reihe nach unter die Öffnung 37 gebracht werden können, damit ihnen Bauelemente zur Bestückung der Trägerplatte 30 entnommen werden können. Die Öffnung 37 entspricht daher in ihrer Grösse im wesentlichen dem horizontalen Umfang der Gefässe 38.

Bei der Bestückung von Trägerplatten mit Bauelementen werden in der Regel wesentlich mehr als acht verschiedene Arten von Bauelementen benötigt. Die Gefässe 38 sind daher durch herausnehmbare Trennwände 40 in acht einzelne Fächer 42 unterteilt. In den einzelnen Fächern 42 befinden sich die verschiedenen Bauteiltypen in einer dem Arbeitsablauf entsprechenden Reihenfolge.

Die Gefässe 38 sind beidendig an zwei endlosen Ketten befestigt, die zwei Schleifen mit gemeinsamer horizontaler Schleifenachse bilden, d.h. die in zwei parallelen vertikalen Ebenen einander gegenüberliegen. Die beiden Kettenschleifen haben die gleiche Form, so dass sich die Gefässe 38 bei der synchronen Bewegung der Ketten längs einer Führungsbahnschleife bewegen, die den Kettenschleifen entspricht. Die Schleifenachse verläuft parallel zur Kante 36. Jede Kettenschleife ist durch zwei vertikal übereinanderliegende gerade Schleifenstücke charakterisiert, die durch zwei annähernd kreisringförmige Schleifenstücke miteinander verbunden sind.

Die der Kante 36 naheliegenden kreisbogenförmigen Schleifenstücke sind jeweils über Einzelumlenkrollen derart geführt, dass die Gefässe 38 zwischen den Einzelumlenkrollen in deren Achsbereich eindringen können. Die von der Kante 36 abgelegenen kreisbogenförmigen Schleifenstücke dagegen sind über die bereits erwähnten Synchronisierumlenkrollen geführt, welche durch eine Synchronisierwelle miteinander verbunden sind. Damit die Gefässe 38 nicht an die Synchronisierwelle anstossen, ist der Durchmesser der Synchronisierumlenkrollen entsprechend gross gewählt.

Das untere gerade Schleifenstück geht tangential in die beiden kreisbogenförmigen Schleifenstücke über. Das obere gerade Schleifenstück dagegen schliesst nur an das um die Einzelumlenkrolle geführte Schleifenstück tangential an, während das um die Synchronisierumlenkrolle geführte Schleifenstück von dem oberen geraden Schleifenstück nach oben wegläuft. Um diese Schleifenform zu erhalten, wird die Kette zwischen der Synchronisierumlenkrolle und der Einzelumlenkrolle längs entsprechender Führungsschienen oder Führungsrollen geführt. Diese Führungsschienen oder Führungsrollen nehmen einen Teil des Gewichts der Gefässe 38 auf.

Damit die Gefässe 38 während des Umlaufs entlang der Führungsbahnschleifen nicht um ihre zur Schleifenachse parallele Längsachse gekippt werden und dadurch die Bauelemente aus den Gefässen 38 herausfallen, sind die Gefässe 38 an den Ketten pendelnd aufgehängt.

Da die Bewegung der beiden Ketten durch die Synchronisierumlenkrollen zwangsläufig synchronisiert ist, genügt es, eine der beiden Ketten anzutreiben. Hierzu ist eine in Fig. 1 gezeigte Kurbel 60 vorgesehen.

Die Gefässe lassen sich leicht auswechseln, da sie lediglich in mit den Ketten fest verbundene Halteelemente eingehängt werden müssen. Die Gefässe 38 sind stapelbar und benötigen daher für die Lagerung nur geringe Abstellfläche. In Fig. 1 sind die für eine komplette Ausrüstung der Montageeinrichtung 10 notwendigen acht Gefässe 38 auf die Montageeinrichtung 10 gestapelt. Um die Standfestigkeit der Stapel zu erhöhen, sind hier die Gefässe 38 mit Gefässdeckeln 39 versehen, die dem jeweils darüber gestapelten Gefäss 38 eine gute Standfläche bieten.

Für Bestückungsarbeiten, bei denen komplizierte mechanische Handgriffe, wie Schraubarbeiten, durchgeführt werden müssen, ist es günstiger, die Trägerplatte 30 möglichst in der Nähe der Bedienungsperson anzuordnen, also im Randbereich 34. Schraubarbeiten beispielsweise lassen sich am besten direkt von oben durchführen. Um auch hier der Bedienungsperson die Bauelemente in bequemer Reichweite anzubieten, kann eine Entnahme-Öffnung in dem der Bedienungsperson abgewandten Randbereich der Arbeitsfläche 16 vorgesehen werden.

In den Fig. 2 bis 4 ist eine mit 110 bezeichnete erfindungsgemässe Montageeinrichtung dargestellt. Bauteile, die denen der Montageeinrichtung 10 gemäss Fig. 1 entsprechen, sind mit den gleichen Bezugsziffern, jeweils vermehrt um die Zahl 100, gekennzeichnet.

Auch hier ist die Entnahme-Öffnung 137 zwischen der auf der Halterung 128 befestigten Trägerplatte 130 und der am Sitzplatz 132 vor der Montageeinrichtung 110 sitzenden Bedienungsperson angeordnet, also im Randbereich 134 der Arbeitsfläche 116. Die Grösse der Entnahme-Öffnung 137 entspricht jedoch lediglich der Grösse eines Faches 142 der Gefässe 138. Damit den Fächern 142 der Reihe nach Bauteile entnommen werden können, sind die Einzelumlenkrollen 158 und die Synchronisierumlenkrollen 126 in einem Schlitten 170 gelagert, der parallel zu der der Bedienungsperson zugewandten Kante 136 der Arbeitsfläche 116 in einer Schlittenführung verschiebbar ist. Diese Schlittenführung ist durch zwei Führungsstangen 172 schematisch dargestellt, die entsprechende Bohrungen 174 im Schlitten 170 durchsetzen. Die Schlittenführung kann jedoch auch in anderer Weise, wie zum Beispiel durch auf Schienen laufende Führungsräder verwirklicht werden.

In Fig. 2 ist mit durchgezogenen Linien eine Endposition des Schlittens 170 gezeigt, in der die Entnahme-Öffnung 137 sich oberhalb des Faches 142 am linken Ende des Gefässes 138 befindet. Mit unterbrochenen Linien ist die entgegengesetzte Endposition des Schlittens 170 dargestellt, in der sich die Entnahme-Öffnung 137 über dem Fach 142 am rechten Ende des Gefässes 138 befindet. Zwischen diesen beiden Endpositionen wird der Schlitten 170 in der Facheinteilung entsprechenden Bewegungsschritten bewegt.

Für den Antrieb der Ketten 152 wird ein erster motorischer Antrieb 176 verwendet, der die Synchronisierwelle 127 antreibt. Die Verschiebung des Schlittens 170 wird über einen zweiten motorischen Antrieb 178 vorgenommen, der eine Spindel 180 antreibt, auf der eine mit dem Schlitten 170 starr verbundene Spindelmutter 182 läuft.

Die beiden motorischen Antriebe 176 und 178 sind mit einem Positionssteuersystem 184 verbunden, von dem sie gesteuert werden. Das Positionssteuersystem 184 ist an ein Betätigungselement, beispielsweise einen Taster 186, angeschlossen. Sobald die Bedienungsperson neue Bauteile benötigt, betätigt diese den Taster 186, woraufhin das Positionssteuersystem 184 an die Antriebe 176, 178 Steuerbefehle zur Einstellung eines neuen Faches 142 unterhalb der Entnahme-Öffnung 137 abgibt. Durch Verwendung eines programmierbaren Positionssteuersystems 148, beispielsweise eines Mikroprozessors, ergibt sich die Möglichkeit, unter die Entnahme-Öffnung 137 nacheinander beliebige Fächer 142 beliebiger Gefässe 138 entsprechend eines eingegebenen Programms zu bringen. Mit einer für mehrere verschiedene Trägerplatten 130 geeigneten Standardfüllung der Gefässe 138 mit Bauelementen lässt sich die Montageeinrichtung 110 von einem Trägerplattentyp auf den nächsten Trägerplattentyp in einfacher Weise durch Änderung des Programms im Positionssteuersystem 184 umstellen. Dieses bedeutet eine erhebliche Vereinfachung gegenüber dem sonst notwendigen Austausch des gesamten Satzes von Gefässen 138 der Montageeinrichtung 110.

Das Positionssteuersystem 184 kann auch mit einer Steuerungseinrichtung für eine Bestückungsortsanzeige verbunden werden. Bei einer solchen Bestückungsortsanzeige wird ein optisches Signal auf der Trägerplatte, beispielsweise ein Leuchtpunkt am Bestückungsort erzeugt.

Bei ruckartigem Anfahren und Abbremsen der Ketten 152 wird auf die Gefässe 138 ein Kippmoment ausgeübt, ebenso bei der Bewegung der Gefässe um die Synchronisierumlenkrollen 126 und die Einzelumlenkrollen 158. Um ein Kippen der Gefässe 138 zu verhindern, sind die Gefässe 138 beidendig starr mit Winkeln 188 verbunden, an denen Leitelemente 190 befestigt sind, die in Leitbahnen 192 innerhalb des Schlittens 170 laufen. Zur Vereinfachung der Darstellung sind die Winkel 188, die Leitelemente 190 sowie die Leitbahnen 192 lediglich auf der rechten Seite des Rahmens 170 eingezeichnet. Der rechte vordere Teil des Rahmens 170 ist teilweise abgebrochen dargestellt.

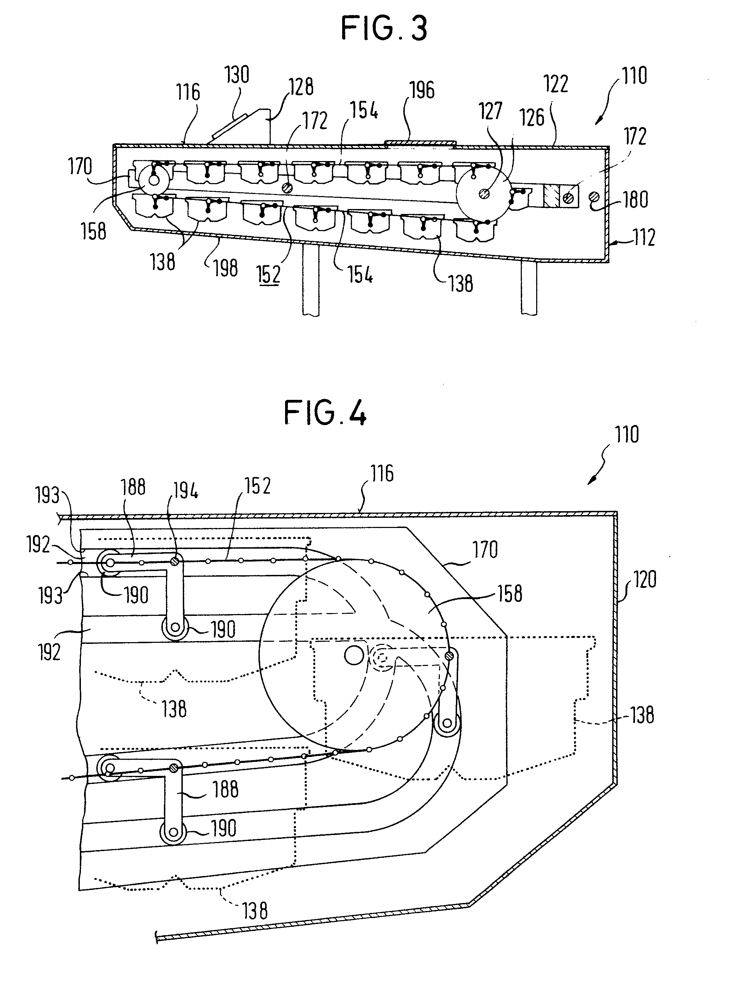

In Fig. 4 sind die oberhalb der Zeichnungsebene befindlichen Gefässe 138 punktiert gezeichnet. Die Winkel 188 sind durch an den Ketten 152 befestigte Verbindungsbolzen 194 drehfest mit den Gefässen 138 verbunden. An den Enden jedes Winkels 188 sind die als Rollen ausgeführten Leitelemente 190 befestigt, die wiederum in den in die innere Seitenfläche des Rahmens 170 eingefrästen nutenförmigen Leitbahnen 192 laufen.

Durch die Verwendung jeweils zweier Leitelemente 190 erreicht man, dass das Gefäss 138 auch bei grossen Kippmomenten auf seinem Umlauf nicht kippt. In den geraden Schleifenstücken 154 der Kettenschleife sorgt in erster Linie das in horizontaler Richtung gegenüber dem Verbindungsbolzen 194 versetzte Leitelement 190 dafür, dass das Gefäss 138 nicht kippt, da dieses Leitelement 190 bei einer Kippbewegung sich senkrecht zu seiner Leitbahn 192 bewegt und sofort an der oberen oder der unteren Fläche seiner Leitbahn 192, der oberen oder unteren Leitfläche 193, anstösst. Dementsprechend verhindert vor allem das in vertikaler Richtung gegenüber dem Verbindungsbolzen 194 versetzte Leitelement 190 das Kippen des Gefässes 138, wenn sich dieses bei seiner Kreisbahn um die Umlenkrollen 126 oder 158 in vertikaler Richtung bewegt. In den restlichen Bereichen der Kreisbahn wirken beide Leitelemente 190 zusammen. Zwischen den Umlenkrollen 126 und 158 nimmt das nach unten versetzte Leitelement 190 das Gewicht des Gefässes 138 auf, so dass sich die Kette 152 unterstützende Führungsschienen oder Führungsrollen erübrigen.

Aufgrund der kippsicheren Führung der Gefässe 138 kann man die Antriebsgeschwindigkeit der Ketten 152 wesentlich heraufsetzen. Eine obere Grenze wird lediglich durch die Schwerkraft festgelegt, da die Gefässe 138 in den Umlenkbereichen nicht mit einer grösseren Beschleunigung nach unten bewegt werden dürfen, als die Fallbeschleunigung. In der in den Fig. 2 bis 4 gezeigten erfindungsgemässen Montageeinrichtung 110 wird eine Umlaufzeit der Gefässe 138 von ca. 1,5 Sekunden erreicht. Da zum Verfahren der Schlitten 170 aus der linken Endposition in die rechte und umgekehrt weniger als 1,5 Sekunden benötigt werden, können innerhalb dieser Zeit beliebige Fächer 142 unter die Entnahme-Öffnung 137 gebracht werden. Die Bestückung einer Trägerplatte kann also ohne Verzögerung durch grössere Transportzeiten durchgeführt werden.

Die Kettenschleife der erfindungsgemässen Montageeinrichtung 110 ist länger als die der Montageeinrichtung 10, so dass eine grössere Anzahl (15 Stück) von Gefässen 138 zwischen die Ketten 152 eingehängt werden kann. Bei acht Fächern 142 pro Gefäss 138 stehen auch für umfangreiche Bestückungsarbeiten ausreichend viele verschiedene Bauelemente zur Verfügung.

Im Gegensatz zur Montageeinrichtung 10 ist das Abdeckblech 122 des Gehäuses 112 der Montageeinrichtung 110 durchgehend eben, mit einer Gefässentnahmeklappe 196 zum Auswechseln der Gefässe 138 (siehe Fig. 3).

Die Kettenschleife der Montageeinrichtung 110 besitzt auch eine etwas andere Form. Die Kette 152 ist straff gespannt, um grosse Beschleunigungen zu ermöglichen. Die Synchronisierumlenkrolle 126 ist derart nach unten versetzt, dass das obere gerade Schleifenstück 154 horizontal verläuft, während das untere gerade Schleifenstück 154 in Richtung zu der Synchronisierumlenkrolle 126 hin nach unten geneigt ist. Da der Abstand zwischen der Einzelumlenkrolle 158 und der Synchronisierumlenkrolle 126 relativ gross ist, ist die Neigung des unteren Schleifenstücks 154 und des zu diesem parallelen Bodenblechs 198 des Gehäuses 120 gering, so dass auch hier für die Knie der Bedienungsperson ausreichend Platz ist.

**Patentansprüche**

1. Montageeinrichtung (110) zur Bestückung von Trägerplatten (130) mit Bauelementen, insbesondere zur Bestückung von Schaltungsträgerplatinen mit elektrischen Bauelementen mit einer Arbeitsfläche (116), mit einer Halterung (128) für die Trägerplatte (130) an der Oberseite der Arbeitsfläche (116) längs einer Führungsbahnschleife geführten Aufnahmen (138) für die Bauelemente, von denen jeweils mindestens eine Aufnahme (138) durch eine Entnahme-Öffnung (137) in der Arbeitsfläche (116) zugänglich ist, wobei die Achse der Führungsbahnschleife horizontal liegt und die Aufnahmen (138) in Richtung der Schleifenachse länglich ausgebildet sind, dadurch gekennzeichnet, dass die Gesamtheit der Aufnahmen (138) in Richtung der Schleifenachse verschiebbar ist.

2. Montageeinrichtung nach Anspruch 1, dadurch gekennzeichnet, dass die Aufnahmen (138) zwischen zwei in Längsrichtung der Schleifenachse beabstandeten, flexiblen, endlosen Zugmitteln, z.B. Ketten (152), an diesen beidseitig befestigt angeordnet sind und dass die Zugmittel (152) auf einem Schlitten (170) angeordnet sind, welcher in Richtung der Schleifenachse in einer Schlittenführung (172) verschiebbar ist.

3. Montageeinrichtung nach Anspruch 1 oder 2, dadurch gekennzeichnet, dass die Aufnahmen (138) durch einen ersten motorischen Antrieb (176) entlang der Führungsbahnschleife und durch einen zweiten motorischen Antrieb (178) in Richtung der Schleifenachse schrittweise bewegbar sind.

4. Montageeinrichtung nach Anspruch 3, dadurch gekennzeichnet, dass der zweite Antrieb (178) ein Spindelantrieb ist.

5. Montageeinrichtung nach Anspruch 3 oder 4, dadurch gekennzeichnet, dass den beiden Antrieben (176, 178) ein Positionssteuersystem (184) zugeordnet ist, welches den Antrieben (176, 178) einer gewählten Sollposition entsprechende Steuerbefehle abgibt.

6. Montageeinrichtung nach Anspruch 5, dadurch gekennzeichnet, dass das Positionssteuersystem (184) derart ausgebildet ist, dass, von einer Istposition ausgehend, die gewählte Sollposition in kürzest möglicher Zeit erreicht wird.

7. Montageeinrichtung nach einem der Ansprüche 2 bis 6, dadurch gekennzeichnet, dass die Zugmittel (152) im Bereich der der Bedienungsperson zugewandten Kante (136) der Arbeitsfläche (116) über je eine Einzelumlenkrolle (158) geführt sind, derart, dass die Aufnahmen (138) zwischen den Einzelumlenkrollen (158) in deren Achsbereich eindringen können, während im Bereich der der Bedienungsperson abgewandten Kante die Zugmittel (152) über Synchronisierumlenkrollen (126) mit sie verbindender Synchronisierwelle (127) geführt sind, wobei der Durchmesser der Synchronisierumlenkrollen (126) derart bemessen ist, dass die Aufnahmen (138) um die Synchronisierwelle (127) herumlaufen.

8. Montageeinrichtung nach einem der Ansprüche 1 bis 7, dadurch gekennzeichnet, dass die Aufnahmen (138) um eine zur Schleifenachse parallele Pendelachse pendelnd aufgehängt sind und mindestens einendig mindestens ein Leitelement (190) aufweisen, welches in einer Leitbahn (192) derart geführt ist, dass die Aufnahmen (138) zumindest in den Umlenkbereichen der Schleife gegen Kippen gesichert sind.

9. Montageeinrichtung nach Anspruch 8, dadurch gekennzeichnet, dass die Aufnahmen (138) mindestens einendig mit zwei Leitelementen (190) starr verbunden sind, welche in Höhen- und Längsrichtung der Führungsbahnschleife gegeneinander versetzt und in entsprechend gegeneinander versetzten Leitbahnen (192) laufen.

10. Montageeinrichtung nach einem der Ansprüche 1 bis 9, dadurch gekennzeichnet, dass die Länge der Aufnahmen (138) in Richtung der Schleifenachse mindestens 30% vorzugsweise ca. 50% der Ausdehnung der Arbeitsfläche (116) in dieser Richtung beträgt.

11. Montageeinrichtung nach einem der Ansprüche 1 bis 10, dadurch gekennzeichnet, dass die Aufnahmen von Gruppen von in Richtung der Schleifenachse aneinandergereihten Einzelgefässen gebildet sind, welche miteinander gekuppelt oder durch einen gemeinsamen Träger getragen sind.

12. Montageeinrichtung nach einem der Ansprüche 1 bis 10, dadurch gekennzeichnet, dass die Aufnahmen als einstückige, langgestreckte Gefässe (138) ausgebildet sind, welche gegebenenfalls durch Trennwände (140) in Fächer (142) unterteilt sind.

13. Montageeinrichtung nach einem der Ansprüche 1 bis 12, dadurch gekennzeichnet, dass die Schleifenachse parallel zu der der Bedienungsperson zugekehrten Kante (136) der Arbeitsfläche (116) verläuft.

14. Montageeinrichtung nach einem der Ansprüche 1 bis 13, dadurch gekennzeichnet, dass die Entnahme-Öffnung (137) in dem der Bedienungsperson zugekehrten Randbereich (134) der Arbeitsfläche (116) liegt.

15. Montageeinrichtung nach einem der Ansprüche 1 bis 13, dadurch gekennzeichnet, dass die Entnahme-Öffnung in dem der Bedienungsperson abgewandten Randbereich (134) der Arbeitsfläche (116) liegt.

16. Montageeinrichtung nach einem der Ansprüche 1 bis 15, dadurch gekennzeichnet, dass die Entnahme-Öffnung (137) in Richtung der Schleifenachse sich nur über einen Teil der Ausdehnung der Aufnahmen (138) in dieser Richtung erstreckt.

**Claims**

1. An assembly unit (110) for equipping carrier plates (130) with components, more especially for equipping printed circuit boards with electrical components, and comprising a work surface (116), a holder (128) for the carrier plate (130) at the top of the work surface (116) and comprising seats (138) for the components which are guided beneath the work surface (116) along a guideway loop and of which respectively at least one seat (138) is accessible through a withdrawal opening (137) in the work surface (116), the axis of the guideway loop being horizontal and the seats (138) being elongate in design in the direction of the loop axis, characterised in that the entirety of the seats (138) is displaceable in the direction of the loop axis.

2. An assembly unit as claimed in Claim 1, characterised in that the seats (138) are arranged between two flexible endless pulling means which are spaced apart in the longitudinal direction of the loop axis, for example chains (152), being secured thereto on both sides, and in that the pulling means (152) are provided on a carriage (170) which is displaceable in a carriage guide (172) in the direction of the loop axis.

3. An assembly unit as claimed in Claim 1 or 2 characterised in that the seats (138) are movable in steps along the guideway loop by a first motor drive (176) and in the direction of the loop axis by a second motor drive (178).

4. An assembly unit as claimed in Claim 3, characterised in that the second drive (178) is a spindle drive.

5. An assembly unit as claimed in Claim 3 or 4, characterised in that there is associated with the two drives (176, 178) a position control system (184) which emits to the drives (176, 178) control commands which correspond to a selected desired position.

6. An assembly unit as claimed in Claim 5, characterised in that the position control system (184) is designed in such a way that, starting out from an actual position, the selected desired position is reached within the shortest possible time.

7. An assembly unit as claimed in one of Claims 2 to 6, characterised in that in the zone of the work surface (116) edge (136) that is directed towards the operator the pulling means (152) are guided over respectively one individual deflection pulley (158) in such a way that the seats (138), between the individual deflection pulleys (158), can penetrate into the axial zone thereof, while in the zone of the edge that is directed away from the operator, the pulling means (152) are guided over synchronising deflection pulleys (126) which are provided with a synchronising shaft (127) connecting them, the diameter of the synchronising deflection pulleys (126) being so dimensioned that the seats (138) revolve around the synchronising shaft (127).

8. An assembly unit as claimed in one of Claims 1 to 7, characterised in that the seats (138) are suspended so as to swing in pendulum fashion about a pendulum axis that is parallel to the loop axis and have, at least at one end, at least one guiding element (190) which is guided in a guideway (192) in such a way that, at least in the deflection zones of the loop, the seats (138) are protected against tilting.

9. An assembly unit as claimed in Claim 8, characterised in that the seats (138) are rigidly connected, at least at one end, to two guiding elements (190) which are staggered in the vertical and longitudinal directions of the guideway loop and run in guideways (192) which are staggered accordingly.

10. An assembly unit as claimed in one of Claims 1 to 9, characterised in that the length of the seats (138) in the direction of the loop axis is at least 30%, preferably approximately 50% of the extension of the work surface (116) in this direction.

11. An assembly unit as claimed in one of Claims 1 to 10, characterised in that the seats are formed by groups of individual containers which are joined in the direction of the loop axis and which are coupled together or are carried by a joint carrier.

12. An assembly unit as claimed in one of Claims 1 to 10, characterised in that the seats are formed as one-piece elongated containers (138) which may be subdivided into compartments (142) by partition walls (140).

13. An assembly unit as claimed in one of Claims 1 to 12, characterised in that the loop axis extends in parallel with the work surface (116) edge (136) that is directed towards the operator.

14. An assembly unit as claimed in one of Claims 1 to 13, characterised in that the withdrawal opening (137) is located in the work surface (116) edge zone (134) that is directed towards the operator.

15. An assembly unit as claimed in one of Claims 1 to 13, characterised in that the withdrawal opening is located in the work surface (116) edge zone (134) that is directed away from the operator.

16. An assembly unit as claimed in one of Claims 1 to 15, characterised in that in the direction of the loop axis the withdrawal opening (137) extends only over a proportion of the extension of the seats (138) in this direction.

**Revendications**

1. Installation de montage (110) pour garnir d'éléments constitutifs des plaques-supports (130), en particulier pour garnir de composants électriques des plaquettes de circuits, comportant un plan de travail (116), un support (128) pour la plaque-support (130) sur la face supérieur du plan de travail (116) et, audessous de ce plan (116), des réceptacles (136) pour les éléments constitutifs, guidés le long d'un parcours en circuit fermé et dont un au moins est accessible à travers une ouverture de prélèvement (137) mênagée dans le plan de travail (116), l'axe du parcours en circuit fermé étant horizontal et les réceptables (138) ayant une forme allongée dans le sens de cet axe, caractérisée en ce que l'ensemble des réceptacles (138) est déplaçable dans la direction de l'axe du parcours en circuit fermé,

2. Installation de montage selon la revendication 1, caractérisée en ce que les réceptacles (138) sont disposés entre deux moyens de traction sans fin flexibles, placés à une certaine distance l'un de l'autre dans la direction de l'axe du parcours en circuit fermé, par exemple, des chaînes (152), moyens auxquels ils sont fixés par leurs deux extrémités opposées, et en ce que les moyens de traction (152) sont disposés sur un chariot (170) qui est déplaçable dans un guidage (172) dans la direction de l'axe du parcours en circuit fermé.

3. Installation de montage selon la revendication 1 ou 2, caractérisée en ce que les réceptacles (138) sont déplaçables par avancements successifs le long du parcours en circuit fermé au moyen d'un premier mécanisme moteur (176) et dans la direction de l'axe de ce parcours au moyen d'un second mécanisme moteur (178).

4. Installation de montage selon la revendication 3, caractérisée en ce que le second mécanisme moteur (178) est un mécanisme à vis-mère.

5. Installation de montage selon la revendication 3 ou 4, caractérisée en ce qu'aux deux mécanismes moteurs (176, 178) est associé un système du commande de position (184), qui envoie aux dits mécanismes (176, 178) des ordres de commande correspondants à une position de consigne choisie.

6. Installation de montage selon la revendication 5, caractérisée en ce que le système de commande de position (184) est conçu de façon qu'à partir d'une position effective, la position de consigne choisie soit atteinte en un temps aussi court que possible.

7. Installation de montage selon l'une quelconque des revendications 2 à 6, caractérisée en ce que les moyens de traction sont, dans la zone du chant (136) du plan de travail (116) tourné vers l'opérateur, passés chacun autour d'une poulie de renvoi individuelle (158) de telle façon que les réceptacles (138) peuvent pénétrer entre les poulies de renvoi individuelles (158) dans la zone de leur axe, tandis que dans la zone du chant tourné vers l'opposé de l'opérateur, les moyens de traction (152) sont passés autour de poulies de renvoi synchronisées (126) munies d'un arbre de synchronisation (127) qui les relie l'une à l'autre, le diamètre des poulies de renvoi synchronisées (126) étant dimensionné de façon que les réceptacles (138) passent autour de l'arbre de synchronisation (127).

8. Installation de montage selon l'une quelconque des revendications 1 à 7, caractérisée en ce que les réceptacles (138) sont suspendus et oscillent autour d'un axe parallèle à l'axe du parcours en circuit fermé et, au moins à l'une de leurs extrémités, comportent au moins un élément de guidage (190), qui est guidé dans une voie (192) de telle façon que les réceptacles (138) ne peuvent basculer, au moins dans les zones de renvoi du parcours en circuit fermé.

9. Installation de montage selon la revendication 8, caractérisée en ce que les réceptacles (138) sont, à l'une au moins de leurs extrémités, liés rigidement à deux éléments de guidage (190), qui sont décalés en hauteur et dans le sens longitudinal du parcours en circuit fermé l'un relativement à l'autre et se déplacent dans des voies (192) décalées de façon correspondante.

10. Installation de montage selon l'une quelconque des revendications 1 à 9, caractérisée en ce que la longueur des réceptacles (138) dans la direction de l'axe du parcours en circuit fermé, est égale à au moins 30%, de préférence environ 50%, de l'étendue du plan de travail (116) dans cette même direction.

11. Installation de montage selon l'une quelconque des revendications 1 à 10, caractérisée en ce que les réceptacles sont formés par des groupes de récipients individuels juxtaposés dans la direction de l'axe du parcours en circuit fermé, qui sont accouplés les uns aux autres ou portés par un support commun.

12. Installation de montage selon l'une quelconque des revendications 1 à 10, caractérisée en ce que les réceptacles sont conformés en récipients (138) très alongés, faits d'une seule pièce, divisés éventuellement en compartiments (142) par des cloisons (140).

13. Installation de montage selon l'une quelconque des revendications 1 à 12, caractérisée en ce que l'axe du parcours en circuit fermé s'étend parallèlement au chant (136) du plan de travail (116) tourné vers l'opérateur.

14. Installation de montage selon l'une quelconque des revendications 1 à 13, caractérisée en ce que l'ouverture de prélèvement (137) se trouve dans la zone (134) du chant du plan de travail (116) tourné vers l'opérateur.

15. Installation de montage selon l'une quelconque des revendications 1 à 13, caractérisée en ce que l'ouverture de prélèvement (137) se trouve dans la zone (134) du chant du plan de travail (116) tourné vers l'opposé de l'opérateur.

16. Installation de montage selon l'une quelconque des revendications 1 à 15, caractérisée en ce que l'ouverture de prélèvement (137) s'étend dans la direction de l'axe du parcours en circuit fermé, sur une partie seulement de l'étendue des réceptacles (138) dans cette direction.

# FIG.1

FIG. 2

0 005 513

# FIG. 3

# FIG.4